# EUROPEAN PATENT SPECIFICATION

(11) **EP 3 796 010 B1**
(45) Date of publication and mention of the grant of the patent: **04.10.2023**
(21) Application number: 20190824.1
(22) Date of filing: 13.08.2020
(51) Int. Cl.: G01R 31/11

(54) **SYSTEM AND METHODS FOR ON-CHIP TIME-DOMAIN REFLECTOMETRY**
SYSTEME UND VERFAHREN ZUR ON-CHIP-ZEITBEREICHSREFLEKTOMETRIE
SYSTÈMES ET PROCÉDÉS DE RÉFLECTOMÉTRIE DE DOMAINE TEMPOREL SUR PUCE

(30) Priority: 19.09.2019 US 201962902429 P; 10.04.2020 US 202016846024
(43) Date of publication of application: 24.03.2021
(73) Proprietor: MediaTek Singapore Pte. Ltd., Singapore 138628 (SG)
(72) Inventor: CHEN, Huan-Sheng, 30078 Hsinchu City (TW); PARK, Henry Arnold, Irvine, CA 95134 (US); ALI, Tamer Mohammed, Irvine, CA 92620 (US)
(74) Representative: Hoefer & Partner Patentanwälte mbB

(56) References cited:
- EP-A1- 3 502 717
- US-A- 5 319 311
- US-A1- 2010 176 815
- US-A1- 2010 211 338
- US-A1- 2015 077 131
- US-A1- 2017 023 632

## Description

### FIELD OF INVENTION

The present application relates to methods for identifying defective parts in electronic circuits.

### BACKGROUND

Electronic systems are inevitably subject to defective parts, such as incomplete solders, broken cables, misconnections, defective sockets, etc. These defective parts can negatively affect, or even destroy, the operation of the electronic systems. Detection of these defective parts is very onerous, since it involves disassembling the entire system and then probing all its parts until the defect is identified. This process is especially cumbersome in data center applications, in which the number of lines and connections can be in the thousands or even more.

US 2010/176815 A1 describes an apparatus for obtaining a time-domain-reflection response-information that has a signal driver adapted to apply two pulses of different pulse lengths to a TDR port in order to excite a first TDR response signal corresponding to a first pulse and a second TDR response signal corresponding to a second pulse. The apparatus has a timing determinator adapted to provide a timing information on the basis of a first instance in time when the first TDR response signal crosses a threshold value and on the basis of a second instance in time when the second TDR response signal crosses the threshold value. The apparatus has a TDR response information calculator adapted to calculate an information about a TDR response on the basis of the timing information.

US 5 319 311 A describes two or more rising pulse waves having different rates of voltage increase being applied to a measuring end of a cable and reflected waves from a fault point on the cable being detected to measure a turnaround propagation time between the measuring end and the fault point. Additionally, ratios of the rates of voltage increase of one pulse wave and the other pulse waves are calculated. A discharge delay time at the fault point is calculated from time differences of the measured turnaround propagation time and the ratios of the voltage increasing speeds and the discharge delay time is subtracted from the measured turnaround propagation time to calculate a real turnaround propagation time.

US 2015/077131 A1 describes a method of testing a cable by distributed reflectometry, that comprises: injecting into the cable a first periodic signal and a second periodic signal having the same number N of periods and the same number M of samples per period as the first signal; acquiring a measurement of the reflection, from impedance discontinuities of the cable, of each of said first and second signals; taking the average of said measurements of the reflection of at least one of said first or second signals over all of its periods to produce at least one reflectogram; determining the positions of faults in the cable on the basis of at least the reflectogram; the method being wherein each period of the second signal is injected into the cable with a delay or an advance which has an increasing predetermined absolute value for each successively injected period.

US 2010/211338 A1 describes a method and a device for analyzing electric cable networks in order to detect and locate defects in the cables comprising at least one branch connection from which N secondary sections extend. The method involves injecting into the network, at a plurality of injection points E, pseudo-random sequences of digital signals PNᵢ(t) that are de-correlated from each other, and collecting, at one or more observation points Sj, composite time signals Rj(t) generated by the circulation of the output sequences and the reflections thereof in the impedance discontinuities of the network. The correlation between the composite signals and the time-offset pseudo-random sequences is then computed, and the positions of correlation peaks are sought to deduce therefrom the positions of defects in the network by taking into account the signal propagation speed in the network.

### BRIEF SUMMARY

One embodiment, as defined in the independent claim 1, relates to a method for determining a characteristic of a defect in an electrical line of an electronic system, the method comprising (i) selecting a first clock signal among a plurality of selectable clock signals, wherein each selectable clock signal exhibits a different delay relative to a master clock signal; (ii) selecting a first reference voltage among a plurality of selectable reference voltages; (iii) obtaining a signal by: producing a first signal transition onto the electrical line; and receiving a second signal transition arising in response to a reflection of the first signal transition from the defect; (iv) producing a plurality of numerical values by digitizing the signal, wherein each numerical value represents a voltage of the signal, wherein the digitizing is timed using the selected clock signal; (v) producing a plurality of output values by comparing the plurality of numerical values with the selected reference voltage; and (vi) determining the characteristic of the defect based on the plurality of output values.

The method further comprises (vii) selecting a second reference voltage different from the first reference voltage; and (viii) repeating (iii)-(vi).

The method further comprises (ix) selecting a second clock signal different from the first clock signal, such that the first and second clock signals exhibit different delays relative to the master clock signal; and (x) repeating (ii)-(vi). Selecting the first clock signal among the plurality of selectable clock signals comprises selecting a delay value from a plurality of selectable delay values and delaying a master clock signal by an amount corresponding to the selected delay value.

Determining the characteristic of the defect based on the plurality of output values comprises determining a location of the defect based on the plurality of output values.

Determining the characteristic of the defect based on the plurality of output values comprises determining an impedance of the defect based on the plurality of output values.

Determining the characteristic of the defect based on the plurality of output values comprises determining whether the defect is a short or an open circuit.

Producing the first signal transition onto the electrical line is performed using a signal driver. The method further comprises generating data comprising a plurality of bits representing information to be sent to a data receiver; and with the signal driver, outputting the data onto the electrical line.

Another embodiment, as defined in the independent claim 9, relates to an apparatus for determining a characteristic of a defect in an electrical line of an electronic system. The apparatus comprises a clock selection circuit configured to select a first clock signal among a plurality of selectable clock signals wherein each selectable clock signal exhibits a different delay relative to a master clock signal; a reference voltage generator configured to select a first reference voltage among a plurality of selectable reference voltages; a transmitter configured to obtain a signal by: producing a first signal transition onto the electrical line; and receiving a second signal transition arising in response to a reflection of the first signal transition from the defect; an analog-to-digital converter configured to produce a plurality of numerical values by digitizing the signal, wherein each numerical value represents a voltage of the signal, wherein the digitizing is timed using the selected clock signal; a comparator configured to produce a plurality of output values by comparing the plurality of numerical values with the selected reference voltage; and a time-domain reflectometry circuit configured to determine the characteristic of the defect based on the plurality of output values.

The reference voltage generator is further configured to select a second reference voltage different from the first reference voltage. The comparator is further configured to produce a second plurality of output values by comparing the plurality of numerical values with the selected second reference voltage. The clock selection circuit is further configured to select a second clock signal different from the first clock signal such that the first and second clock signals exhibit different delays relative to the master clock signal. The digitizing is timed using the selected second clock signal. Selecting the first clock signal among the plurality of selectable clock signals comprises selecting a delay value from a plurality of selectable delay values and delaying the master clock signal by an amount corresponding to the selected delay value. Determining the characteristic of the defect based on the plurality of output values comprises determining an impedance of the defect based on the plurality of output values.

The foregoing summary is provided by way of illustration and is not intended to be limiting. The description and drawings also present non-claimed embodiments, implementations, aspects, and examples for the better understanding of the claimed embodiments defined by the claims. In this respect, the scope of the invention is defined by the claims.

### BRIEF DESCRIPTION OF DRAWINGS

The accompanying drawings are not intended to be drawn to scale. In the drawings, each identical or nearly identical component that is illustrated in various figures is represented by a like numeral. For purposes of clarity, not every component may be labeled in every drawing.
FIG. 1 is a schematic diagram illustrating an electronic system with various electronic components interconnected to each other via electrical lines, according to some non-limiting embodiments.
FIG. 2A is a schematic diagram illustrating a signal driver and an electrical line having a defect, according to some non-limiting embodiments.
FIG. 2B is a plot illustrating how a signal transition output by the signal driver of FIG. 2A propagates along the electrical line, according to some non-limiting embodiments.
FIG. 2C illustrates an example of a signal driver output in the presence of an open circuit in an electrical line, according to some non-limiting embodiments.
FIG. 2D illustrates an example of a signal driver output in the presence of a defect having finite impedance greater than the electrical line's characteristic impedance, according to some non-limiting embodiments.
FIG. 2E illustrates an example of a signal driver output in the absence of defects in the electrical line, according to some non-limiting embodiments.
FIG. 2F illustrates an example of a signal driver output in the presence of a defect having finite impedance less than the electrical line's characteristic impedance, according to some non-limiting embodiments.
FIG. 2G illustrates an example of a signal driver output in the presence of a short circuit in an electrical line, according to some non-limiting embodiments.
FIG. 3 is a plot illustrating schematically a technique for determining the location of a defect along an electrical line based on the identification of two events, according to some non-limiting embodiments.
FIG. 4 is a circuit diagram illustrating an example of a control circuit implementing the technique illustrated in FIG. 3, according to some non-limiting embodiments.
FIG. 5A is a plot illustrating the output of a gate in the presence of glitches, according to some non-limiting embodiments.
FIG. 5B is a plot illustrating the output of a gate in which glitches have been removed, according to some non-limiting embodiments.
FIG. 5C is a circuit diagram illustrating another example of a control circuit implementing the technique illustrated in FIG. 3, according to some non-limiting embodiments.
FIG. 6A is a plot illustrating a signal driver output in the presence of an open circuit, according to some non-limiting embodiments.
FIG. 6B is a plot illustrating the output of a counter when the signal driver output of FIG. 6A is produced, according to some non-limiting embodiments.
FIG. 6C is a plot illustrating a signal driver output in the presence of a defect having a 80Ω impedance, according to some non-limiting embodiments.
FIG. 6D is a plot illustrating the output of a counter when the signal driver output of FIG. 6C is produced, according to some non-limiting embodiments.
FIG. 6E is a plot illustrating a signal driver output in the presence of a defect having a 20Ω impedance, according to some non-limiting embodiments.
FIG. 6F is a plot illustrating the output of a counter when the signal driver output of FIG. 6E is produced, according to some non-limiting embodiments.
FIG. 6G is a plot illustrating a signal driver output in the presence of an short circuit, according to some non-limiting embodiments.
FIG. 6H is a plot illustrating the output of a counter when the signal driver output of FIG. 6G is produced, according to some non-limiting embodiments.
FIG. 6I is a plot illustrating another signal driver output in the presence of a defect having a 20Ω impedance, according to some non-limiting embodiments.
FIG. 6J is a plot illustrating the output of a counter when the signal driver output of FIG. 6I is produced, according to some non-limiting embodiments.
FIG. 6K is a plot illustrating a signal driver output in the presence of an open circuit, according to some non-limiting embodiments.
FIG. 6L is a plot illustrating the output of a counter when the signal driver output of FIG. 6K is produced, according to some non-limiting embodiments.
FIG. 7A is a flowchart illustrating a representative method for determining the location of a defect along an electrical line, according to some non-limiting embodiments.
FIG. 7B is a plot illustrating a representative signal driver output and a plurality of threshold values, according to some non-limiting embodiments.
FIG. 7C is a histogram illustrating the occurrences of crossing events, according to some non-limiting embodiments.
FIG. 7D is a plot illustrating another representative signal driver output and a plurality of threshold values, according to some non-limiting embodiments.
FIG. 7E is another histogram illustrating the occurrences of crossing events, according to some non-limiting embodiments.
FIG. 8A is a circuit diagram illustrating an example of a control circuit including an analog-to-digital converter, according to some non-limiting embodiments.
FIG. 8B is a plot illustrating a set of selectable clock signals, according to some non-limiting embodiments
FIG. 8C is a flowchart illustrating a representative method for determining a characteristic of a defect along an electrical line, according to some non-limiting embodiments.
FIG. 8D is a plot illustrating how a signal may be sampled over several clock cycles, over several loops over the selectable clock signals and over several reference voltages, in accordance with some non-limiting embodiments.
FIGs. 8E-8H are tables representing a plurality of output values, in accordance with some non-limiting embodiments.

### DETAILED DESCRIPTION

### I. Overview

The inventors have developed circuits for detecting the presence, location and/or other characteristics of defects (such as incomplete solders, broken cables, misconnections, defective sockets, opens, shorts, etc.) in large electronic systems that can be co-integrated with other electronic circuits. The circuits developed by the inventors are based on time-domain reflectometry (TDR), a measurement technique used to determine the characteristics of electrical lines by observing reflected waveforms.

Conventional techniques rely on dedicated hardware for performing time-domain reflectometry. As a result, performing time-domain reflectometry on a system may involve several steps before the system can be tested. Some such steps include, for example, powering down the system, disconnecting cables or other connectors from the system, moving the system to a suitable location for testing, and connecting the system to be tested to a dedicated TDR instrument. The result is the disruption of the regular operation of the system when a test is needed.

The TDR circuits developed by the inventors are co-integrated directly with the system to be tested. This means that the system may be tested for the presence or other characteristics of defects without having to disrupt its operations. Being co-integrated, in some embodiments, a TDR circuit may share hardware with other electronic circuits. For example, the same transmitter hardware may serve both as data transmitter and as TDR transmitter. Having shared hardware is particularly suitable for use in connection with large-scale circuits, such as those used in data centers, which can include several thousands of transmitters. In this scenario, in fact, instead of having to design ad-hoc TDR transmitters, designers of TDR systems may leverage existing transmitter hardware, thus reducing design and fabrication costs.

The inventors have appreciated that different methods for performing TDR may be used depending on what defect characteristic(s) a user wishes to determine. In some circumstances, a user may wish to determine the location of a defect, but may not care to know other characteristics of the defect. In these circumstances, the user may be able to take proper measures based on the location of the defect but without necessarily knowing other characteristics. Some embodiments of the present application are directed to methods and circuits for determining the location of a defect. Such embodiments may relay on the use of threshold voltages to identify the timing of certain signal transitions, and to determine the location of a defect based on the timing of these transitions. Such methods are referred to herein as "non-digitizing methods for time-domain reflectometry" or simply "non-digitizing TDR methods."

In other circumstances, however, a user may wish to determine other characteristics of a defect, in addition or in alternative to the location. For example, a user may wish to determine the impedance of a defect, which in turn, may provide an indication of the nature of the defect. The user may use information relating to the nature of defects to discriminate between serious defects (e.g., defects that require repair) and non-serious defects (e.g., defects that do not require repair). Some embodiments of the present application are directed to methods and circuits for determining characteristics of a defect in addition, or in alternative, to the location of the defect. Such embodiments may rely on the use of analog-to-digital converters to profile the waveform of a TDR signal, and may include circuits that determine a characteristic of a defect based on the profile. Such methods are referred to herein as "digitizing methods for time-domain reflectometry" or simply "digitizing TDR methods."

The embodiments that are referring to digitizing methods for time-domain reflectometry are embodiments according to the invention. The embodiments that are referring to non-digitizing methods for time-domain reflectometry are embodiments are not according to the invention but are helpful for understanding the invention.

### II. Non-digitizing methods for time-domain reflectometry

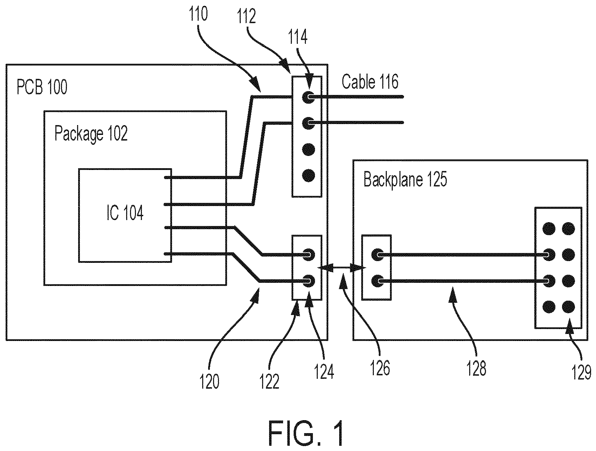

FIG. 1 illustrates an example of an electronic system including multiple electrical lines, according to some non-limiting embodiments. This specific example illustrates an integrated circuit (IC) 104 disposed on a package 102, which is in turn disposed on a printed circuit board (PCB) 100. IC 104 may include various types of analog and/or digital circuits, micromachined (MEMS) devices, sensors and/or other electronic components. IC 104 may include, among others, a processor, a field programmable gate array (FPGA) an application specific integrated circuit (ASIC), a memory unit, and/or any other suitable component. IC 104 may be programmed with instructions that, when executed, carry out different tasks such as transmitting, receiving, and/or processing signals in any suitable manner.

In this example, IC 104 is connected to several electrical lines, where the opposite ends of the electrical lines may be connected to other electronic devices. In some embodiments, IC 104 may be connected to hundreds or even thousands of electrical lines. Each electrical line may include different physical transmission media, such as cables, wires, metal traces, pins, contacts, solders, connectors, sockets, etc. For example, an electrical line may include metal line 110 (which may in turn include a metal trace formed on the package 102, a metal trace formed on PCB 100 and a connector interfacing the metal traces), a contact 114 of connector 112 and cable 116. The other end of cable 116 (not illustrated in FIG. 1) may be connected to some other component or conductive path. Another electrical line may include metal line 120, contact 124 of connector 122, a cable 126, a contact on backplane 125, a metal trace 128 on backplane 125, a connector 129, etc.

Each of the electrical lines connected to IC 104 may, at least in theory, be susceptible to defects. For example, a solder may have been only partially formed, a cable may be defective, a pair of contacts may be mated to one another improperly, a misconnection between pins may occur, a socket may be defective, etc. Such defects may alter the electrical characteristics of the electrical lines. Open or shorts may arise, for example. Additionally, or alternatively, the impedance (e.g., the resistance, capacitance and/or inductance) of the electrical line may increase or otherwise deviate from the expected value. In general, defects in electrical lines are undesirable as they negatively alter the behavior of the electronic system.

Identification of a defect is often a challenging task. First, it may be difficult to identify which electronic components share a defective electrical line. Second, it may be difficult to identify which specific electrical line is defective. Third, it may be difficult to identify which specific component or location along an electrical line is defective. These tasks may be particularly challenging in complex electronic systems, in which there may be several thousands of electrical lines. The techniques described herein provide a practical way for identifying the presence and location of defects in complex systems.

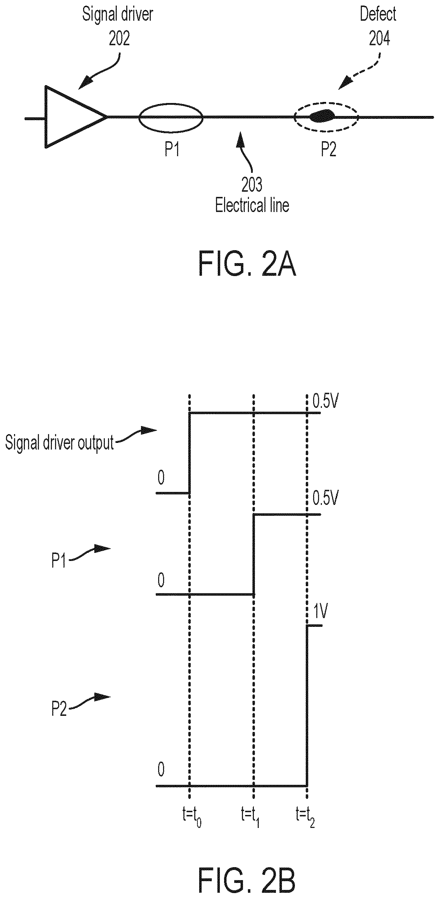

FIG. 2A is a schematic diagram illustrating an electrical line 203 and a signal driver 202 in electrical communication with electrical line 203. Signal driver 202 may be part of IC 104. Signal driver 202 may include circuitry for generating signals to be transmitted across the electrical line 203. For example, signal driver 202 may include amplifiers, buffers, digital-to-analog converters, etc. In this example, electrical line 203 includes a defect 204. The defect 204 may be due to a misconnection, a poorly made solder, a damaged cable, among other possible causes. The presence and the location of defect 204 may be unknown to the user/operator of the electronic system. Depending on its nature, the defect may give rise to an open circuit, to a short circuit to ground, or may simply cause the impedance of the line to deviate from the expected value. In some embodiments, for example, the line's expected impedance is 50Ω but the presence of the defects raises the impedance above or 50Ω, or decreases the impedance below 50Ω.

FIG. 2B is a plot illustrating how a signal output by signal driver 202 onto the electrical line 203 may travel along the electrical line. In this example, the signal driver 202 outputs a signal transition at t=t₀. In this example, it will be assumed, for the sake of illustration, that the signal driver is configured to output transitions from 0 to 1V (referred to as the "desired transition"), and it will be further assumed that the output impedance of the signal driver, the characteristic impedance of the electrical line and the input impedance of the load are all 50Ω. In this case, the transition actually output at t=t₀ has an amplitude that is half (0 to 0.5V) of the desired transition. It should be appreciated that, if the impedances were unmatched, the amplitude of the actual transition would not be half of the desired amplitude transition.

At time t=t₁, the 0-0.5V transition has traveled to location P1 along the electrical line 203, where location P1 is between signal driver 202 and defect 204. At time t=t₂, the transition reaches defect 204 (an open circuit in this case) at location P2. When the transition reaches the defect, the amplitude of the transition increases to the amplitude (0-1V) that the signal driver is configured to output. This is because a signal actually reaches its intended voltage only when a reflection arises. In a hypothetical scenario in which no reflections arise (such as in infinitely long defect-free cables), the amplitude of the transition would never reach the intended value.

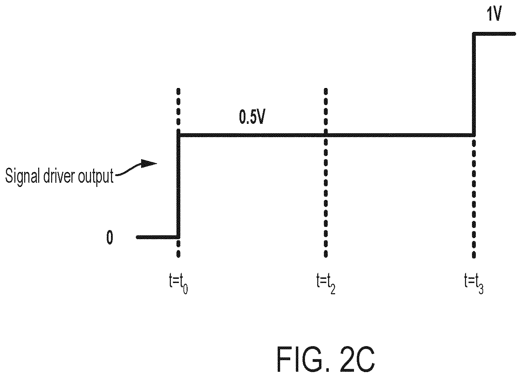

The reflection at location P2 may occur because defect 204 gives rise to a discontinuity in the impedance of the electrical line. The reflected transition may then travel back towards the signal driver 202, and may eventually reach the signal driver. This scenario is illustrated in FIG. 2C, a plot illustrating the output of signal driver 202, also referred to herein as a "TDR signal." The defect is an open circuit in this case. As described above, the first transition (0-0.5V) occurs at t=t₀. At t=t₂, the transition reaches circuit discontinuity, and a reflection arises. However, nothing happens in the output of the signal driver at this time. At time t=t₃, the reflection reaches the signal driver, and as a result, a second transition (0.5V-1V) arises in the output of the signal driver.

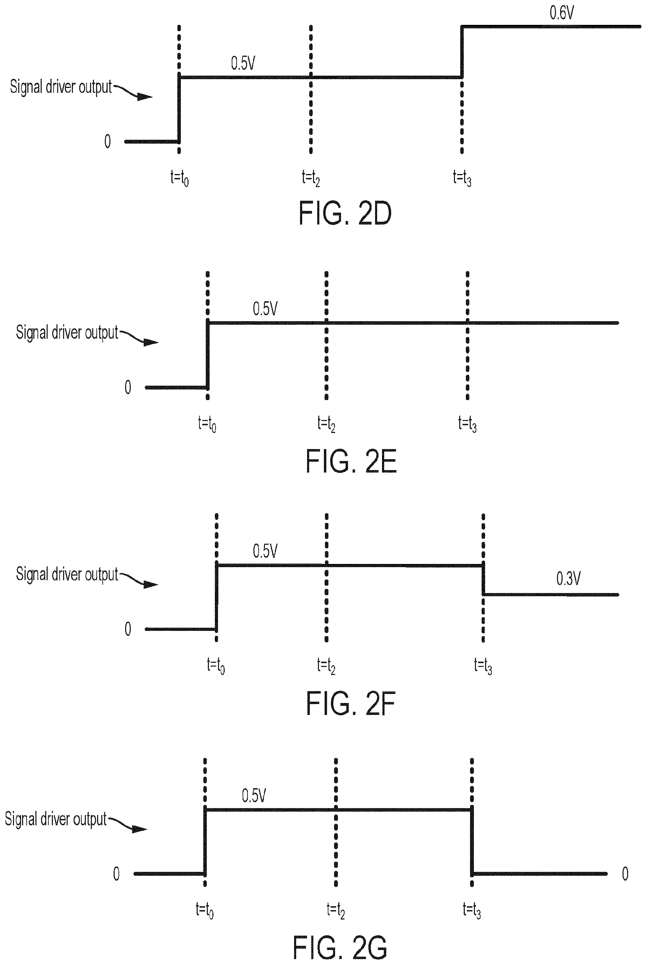

FIG. 2D illustrates an example in which the defect causes the impedance of the line to raise above the line's characteristic impedance. If, by way of example, the characteristic impedance is 50Ω, the defect may raise the impedance to more than 50Ω, such as 70Ω or 80Ω. As illustrated, at t=t₃, the reflection from the defect reaches the signal driver. Unlike the case in which the defect is an open circuit, however, the second transition reaches only 0.7V, instead of 1V. This is due to the fact that the defect has a finite impedance.

FIG. 2E illustrates an example in which there are no defects along the line. As a result, no reflections occur and the signal remains at 0.5V, even after t=t₃.

FIG. 2F illustrates an example in which the defect causes the impedance of the line to decrease below the line's characteristic impedance. If, by way of example, the characteristic impedance is 50Ω, the defect may decrease the impedance to less than 50Ω, such as 20Ω or 30Ω. As illustrated, at t=t₃, the reflection from the defect reaches the signal driver. Because the impedance is less than the characteristic impedance, the amplitude of the signal after t=t₃ is less than 0.5V (0.3V in this example).

FIG. 2G illustrates an example in which the defect causes a short circuit along the line. This case may occur, for example, if the line is unintentionally coupled to a ground plane. In this case, the impedance is zero, and at t=t₃, the signal returns to zero.

Some embodiments are configured to determine the location of defect 204 based on the time it takes the reflected waveform to travel back to the signal driver. For example, some embodiments are configured to determine the location of defect 204 by determining the duration of the time interval Δt=t₃-t₀. In some embodiments, the distance Δx of the defect from the signal driver may be determined by computing Δx=vΔt, where v is the velocity of electrical signals traveling along the electrical path. Velocity v may be measured using different techniques known in the art. Additionally, or alternatively, some embodiments are configured to determine (e.g., measure or estimate) the impedance of the line including the defect or the impedance of the defect itself. The value of the impedance may inform a user whether a replacement part is desirable or not. If, for example, the defect causes the impedance to deviate from the expected value by 5% (or another threshold value) or less, the user may conclude that replacing the part is not necessary. If, on the other hand, the defect causes the impedance to rise or fall by more than 5%, the user may conclude that replacing the part may be desirable.

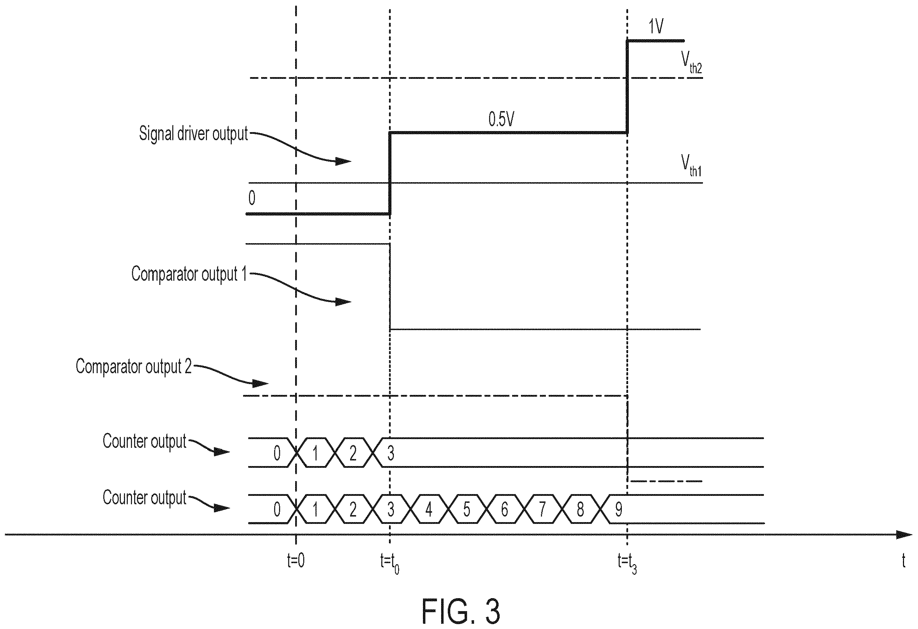

FIG. 3 is a plot illustrating a method for determining the location of a defect, according to some non-limiting embodiments. The plot illustrates the output of signal driver 202. As described above, the output of the signal driver includes a first transition occurring at t=t₀ and a second transition, resulting from the reflection of the first transition from the defect 204, occurring at t=t₃. The location of the defect may be inferred by determining the occurrence of two events. The first event occurs when the first signal transition crosses (e.g., exceeds as in this case, or in other cases, falls under) threshold Vₜₕ₁; the second event occurs when the second transition crosses threshold Vₜₕ₂. In this specific example, Vₜₕ₁=0.2V and Vₜₕ₂=0.8V; however, any other suitable values for the thresholds may be used.

These events may trigger a circuit configured to measure the duration of this time interval. For example, the occurrence of the first event may trigger the output of a comparator to toggle from one value to another (see comparator output 1); the occurrence of the second event may trigger the output of a comparator to toggle from one value to another (see comparator output 2). The location of the defect may be determined based on the duration of the interval between the time when comparator output 1 toggles and the time when comparator output 2 toggles. This may be accomplished, at least in some embodiments, by counting clock cycles. It should be appreciated that while the method described herein used two separate comparators for determining when the signal transitions cross the respective thresholds, in other embodiments a single comparator may be used. The single comparator may, for example, initially receive the first threshold as a first input and subsequently the second threshold as the first input. The signal driver's output may be provided to the comparator's second input. Of course, other methods for measuring the duration of time intervals may be used. In some embodiments, a counter may count clock cycles, and a control circuit may be configured to determine at which clock counts the first and second event occur. In this example, the control circuit may determine that the first event occurs at clock cycle 3, and the second event occurs at clock cycle 9. In some embodiments, the location of the defect may be computed using the following expression: Δx =vΔt = vP(count₂ - count₁), where v is the velocity of the waveform, P is the periodicity of the clock, counti (3 in this case) is the clock count at the occurrence of the first event and count₂ (9 in this case) is the clock count at the occurrence of the second event.

### III. Non-digitizing circuits for time-domain reflectometry

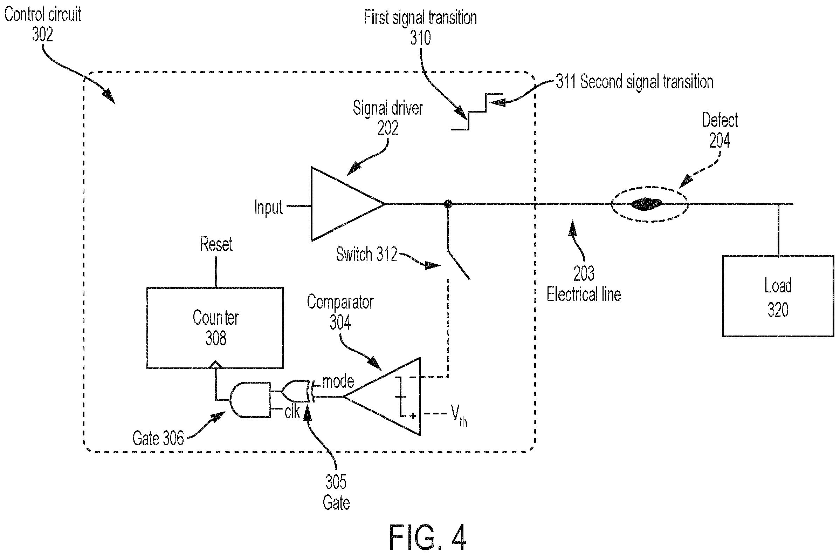

An example of a system for implementing the methods described in connection with FIG. 3 is illustrated in FIG. 4, according to some non-limiting embodiments. Control circuit 302 may be connected to load 320 via electrical line 203. As in the previous examples, electrical line 203 includes a defect 204. Control circuit 302 may be configured to determine the location of defect 204 along the electrical line. In some embodiments, control circuit 302 may further include a digital processor and a memory unit (not illustrated in FIG. 4)

Switch 312 may be closed in the TDR mode, and may be open in the normal mode. In the TDR mode, TDR measurements of the types described herein may be performed. In the normal mode, signal driver 202 may transfer/receive data to/from the load 320. For example, signal "input" may be transmitted to the load 320.

Control circuit 302 may further include comparator 304, gates 305 and 306 and counter 308. In this example, a single comparator is used to compare the first signal transition to the first threshold and the second signal transition to the second threshold. As described above, however, separate comparators may be used to perform the two comparisons. The comparator's input labelled "Vₜₕ" receives the threshold. A control circuit coupled to the Vₜₕ comparator's input may be configured to set the value of the threshold. For example, the control circuit may first set Vₜₕ to Vₜₕ₁, and after a certain period of time has lapsed, may set Vₜₕ to Vₜₕ₂. The time at which Vₜₕ may be set to Vₜₕ₂ may be so that, when the second signal transition is received, this transition is compared to Vₜₕ₂, and not Vₜₕ₁. Of course, the control circuit may not know a priori when the second signal transition will arrive, thus making it difficult to estimate when to set Vₜₕ to Vₜₕ₂. Nonetheless, this challenge may be overcome, for example, by setting Vₜₕ to Vₜₕ₂ after (e.g., after 1 clock cycle, after 2 clock cycles, after 3 clock cycles, etc.) having determined that the first signal transition has crosses the first threshold.

The output of comparator 304 may toggle when a first signal transition 310 crosses Vₜₕ₁ (referred to as the first event), and when a second signal transition 311 crosses Vₜₕ₂ (referred to as the second event). For example, the output of the comparator may enable gate 306 between the first event and the second event, so that the counter increases its clock cycle count only between the first event and the second event. While gate 306 is an AND gate in this example, other logic gates may be used to control the operations of the counter. In another example, the counter 308 may start counting clock cycles at an arbitrary point in time (e.g., at t=0, as shown in FIG. 3). When the first signal transition crosses the first threshold, a control circuit (not shown in FIG. 4) coupled to the counter 308 may determine at which clock cycle count this first event has occurred. Subsequently, when the second signal transition crosses the second threshold, the control circuit may determine at which clock cycle count this second event has occurred. The duration of the interval between the first and second event may then be determined based on these counts. For example, the duration of the interval may be determined by computing the difference between the count at the second event and the count at the first event, multiplied by the period of the clock.

Gate 305 (an XOR gate in this example) may be used to set the mode of operation. In some embodiments, for example, two modes of operation may be possible for the circuits described herein (of course, more than two modes are also possible in other embodiments). One mode of operation may be aimed at determining the location of defects whose impedance is greater than the expected value (as in the case described in connection with FIG. 3), and optionally at determining the value of the impedance. This mode is referred to as the "high-impedance mode." Another mode of operation may be aimed at determining the location of defects whose impedance is less than the expected value, and optionally at determining the value of the impedance. This mode is referred to as the "low-impedance mode."

Because it may not be known a priori whether a defect has an impedance greater or less than the expected value, in some embodiments, the circuit may first be operated in one mode and then in the other mode. In this example, when the "mode" control signal is equal to 0, the circuit operates in the high-impedance mode. Vice versa, when mode=1, the circuit operates in the low-impedance mode. In the high-impedance mode, the counter 308 may count clock cycles if gate 306 is active (e.g., outputs a 1). In the low-impedance mode, the counter 308 may count clock cycles if gate 306 is inactive (e.g., outputs a 0). Examples of different modes of operation are described in section IV of the present disclosure.

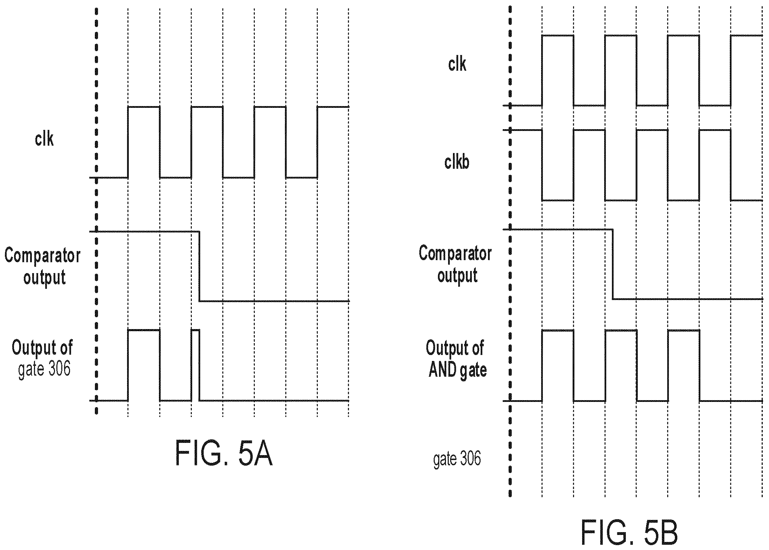

In some embodiments, control circuit 302 may suffer from glitches. Glitches may arise due to the fact that the signal transitions may occur asynchronously relative to the edges of the clock. As a result, the glitch may erroneously cause an increase in the count of the counter 308. This scenario is illustrated in FIG. 5A. As shown, the comparator output toggles in response to a crossing event asynchronously relative to the occurrence of a clock edge. This may erroneously enable gate 306 for a short period of time, which in turn may cause the counter 308 to erroneously increase its count.

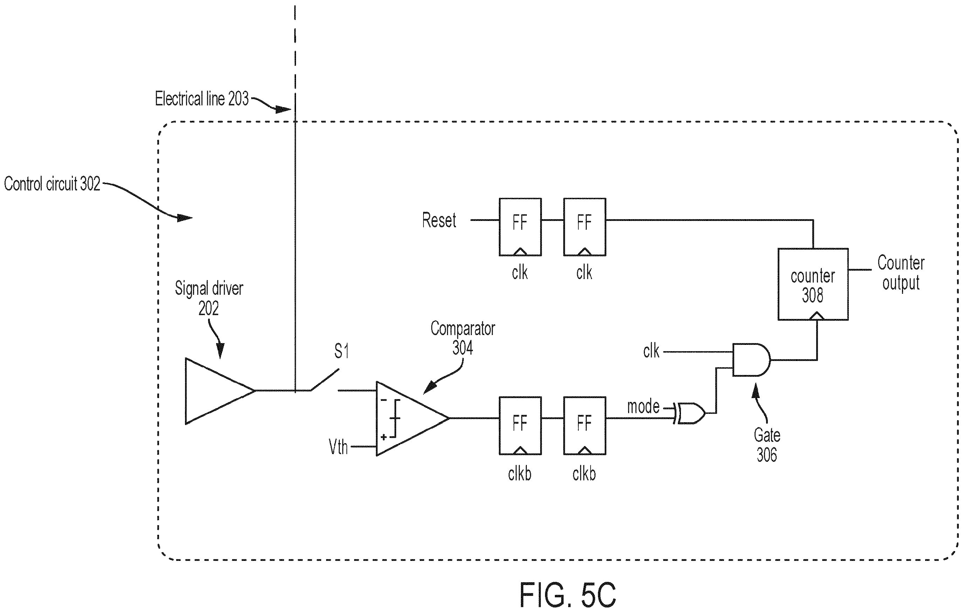

In some embodiments, this problem may be obviated using one or more flip-flops, as illustrated in FIG. 5C, according to some non-limiting embodiments. As shown, a pair of flip-flops (FF) are inserted between comparator 304 and gate 306. The flip-flops may be triggered by clkb, the inverse of clk. FIG. 5B is a plot illustrating the output of gate 306 when flip-flops are used as shown in FIG. 5C. In this case, even though the crossing event does not occur synchronously relative to a clock edge, the output of the gate 306 does not toggle until an edge of clkb is received. As a result, the formation of glitches is prevented. While FIG. 5C illustrates two flip-flops between the comparator 304 and gate 306, any other suitable number of flip-flops may be used. Flip-flop(s) may additionally, or alternatively, be used for the reset signal.

In some embodiments, IC 104 may include a control circuit 302 for each (or at least some) of the electrical lines to which the IC is connected. In this way, multiple TDR measurements may be performed in parallel.

### IV. Modes of operation

As described above, some of the circuits described herein may be operated in two different modes: the high-impedance mode or the low-impedance mode. In the high-impedance mode, a circuit may be arranged to determine the location, and optionally the value of the impedance, of defects whose impedance is greater than the expected value (e.g., the characteristic impedance of the electrical line). FIG. 3 is an example of operations in the high-impedance mode. Additional examples are described below. In some embodiments, two separate modes may be warranted by the fact it may be desirable to set the thresholds differently depending on whether the impedance of the defect is above or below the expected value.

### a. High-impedance mode

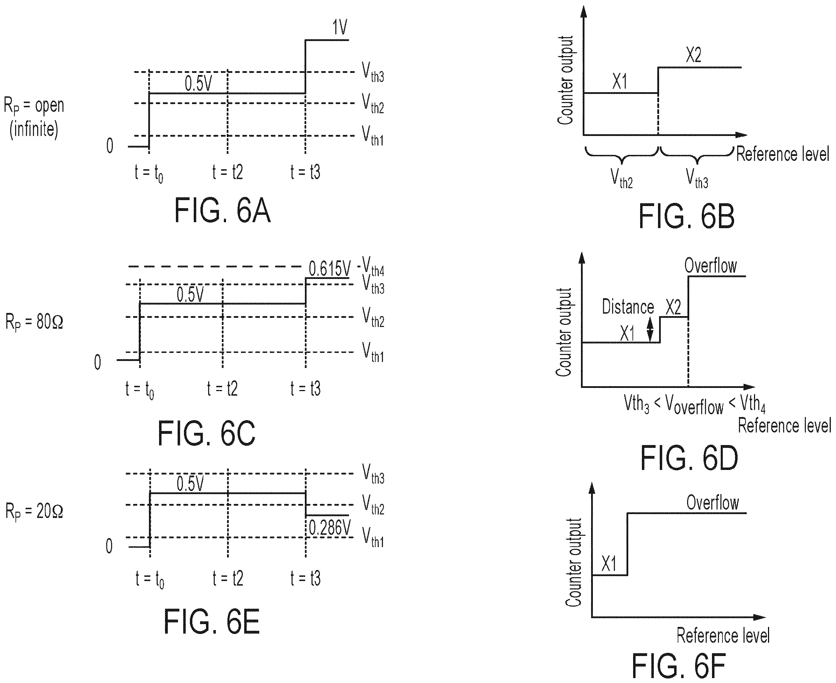

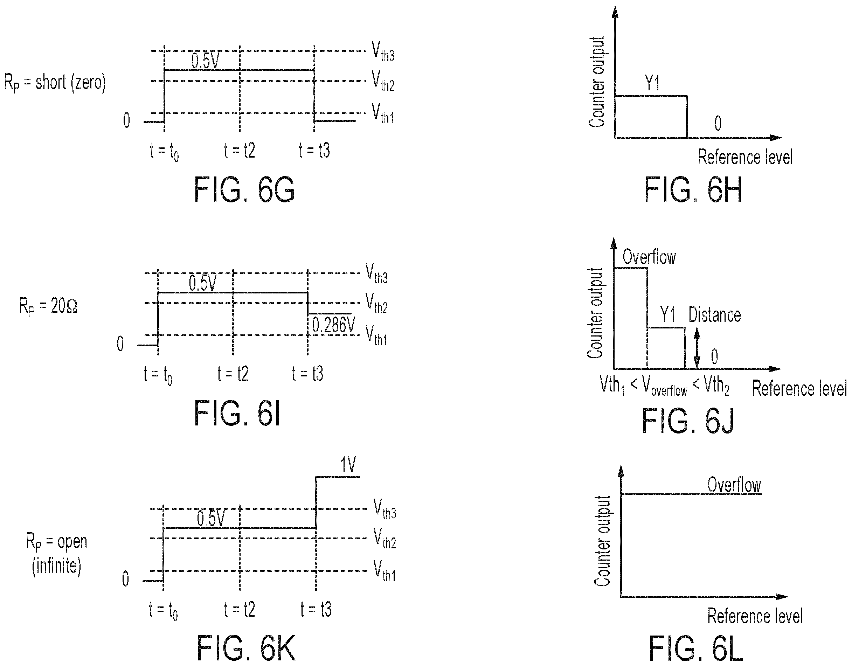

Examples of operation of the methods described herein in the high-impedance mode are illustrated in FIGs. 6A-6F, in accordance with some non-limiting embodiments. Specifically, FIG. 6A illustrates an example in which the defect is an open circuit (infinite resistance); FIG. 6C illustrates an example in which the impedance of the defect is greater than the expected 50Ω-impedance (80Ω in this case); and FIG. 6E illustrates an example in which the impedance of the defect is less that the expected 50Ω-impedance (20Ω in this case). FIG. 6B illustrates the output of the counter expressed in clock cycles in the case of FIG. 6A; FIG. 6D illustrates the output of the counter in the case of FIG. 6C; and FIG. 6F illustrates the output of the counter in the case of FIG. 6E. It should be noted that, while in these examples 50Ω is taken as the expected impedance, other values are also possible as the application is not limited to any specific value.

Referring first to FIGs. 6A-6B, a 0-0.5V transition occurs at t=t₀. In this case, it is assumed that the counter has started counting clock cycles at some time t=0 prior to t₀. The circuit may be arranged such that, when the signal driver output crosses Vₜₕ₂, a counter is disabled and the clock cycle count (i.e., the counter output) is registered (e.g., is stored in a memory). In this case, at the time when the signal driver output crosses Vₜₕ₂, the counter output is X1 (e.g., 3 clock cycles). FIG. 6B illustrates the output of the counter as a function of the threshold voltage that, when crossed, triggers the counter to be disabled. Subsequently, when the signal driver output crosses Vₜₕ₃, a counter (the same counter or another counter) is disabled. At the time the signal crosses Vₜₕ₃, the counter output is X2. As discussed in connection with FIG. 3, the location of the open circuit can be determined based on X2-X1.

Referring now to FIGs. 6C-6D, in which the defect has a 80Ω-impedance, a 0-0.5V transition occurs at t=t₀. When the signal crosses Vₜₕ₂, a counter is disabled and the counter output is X1. Subsequently, when the signal crosses Vₜₕ₃, a counter is disabled and the counter output is X2. As in the previous case, the location of the defect may be inferred based on X2-X1. It should be noted that, unlike the previous case, the voltage of the signal after t₃ is less than 1V (0.615V is this example). The reason for a voltage less than 1V is that the impedance of the defect is finite. In fact, the voltage of the signal after t₃ depends on the impedance of the defect. An infinite impedance leads to a 1V voltage. By contrast, a 50Ω impedance leads to 0.5V. Any value in between produces a voltage between 0.5V and 1V.

The inventors have appreciated that the value of the impedance arising due to the defect may be determined by determining the amplitude of the signal driver output upon being reflected at the defect. In the example of FIG. 6C, an additional threshold-Vₜₕ₄-is introduced. Let's assume, by way of example, that Vₜₕ₄ is set to 0.7V and that Vₜₕ₃ is set to 0.6V. Since the signal never crosses Vₜₕ₄, the counter is never disabled and continues to count. At some point, however, the counter reaches its maximum value. For example, a 10-bit counter reaches its maximum when the counter has counted 1024 clock cycles. When a counter reaches it maximum, it is said to have overflown.

Because the counter has overflown as a result of setting Vₜₕ₄ to 0.7V, it can be inferred that the signal is less than 0.7V. At the same time, it can also be inferred that the signal is greater than Vₜₕ₃=0.6V, since the crossing of that threshold triggered the counter to output X2. As a result, it can be inferred that the signal, after t₃, is between 0.6V and 0.7V, and a result, that the impedance of the defect is between 75Ω and 116Ω. It should be appreciated that the resolution with which the value of the impedance is determined may be increased by increasing the number of thresholds. In one example, ten different thresholds may be introduced between 0 and 1V with 0.1V steps.

The example of FIGs. 6E-6F illustrates why the high-impedance mode may not be suitable for defects with impedance less than 50Ω (or other expected values of impedance). In this case, the impedance of the defect is 20Ω. As in the previous cases, a counter outputs X1 when the signal crosses Vₜₕ₂. Vₜₕ₃, however, is never crossed because the signal falls below 0.5V at t=t₃ (0.286V is this case). As a result, the counter overflows when it reaches its maximum. Accordingly, a second counter output is never generated and the location of the defect may not be determined.

### b. Low-impedance mode

In order to determine the location of defects whose impedance is less than the expected impedance, and optionally to determine the value of the impedance, the logic of the counter may be inverted. This may be accomplished, for example, by setting the mode input of the gate 305 to 1. Unlike in the high-impedance mode, in which the counter is enabled prior to the beginning of the measurement, in the low-impedance mode the counter is enabled by a specific event, such as a signal driver output crossing a predefined threshold. Examples of operation in the low-impedance mode are illustrated in FIGs. 6G-6L, in accordance with some non-limiting embodiments. In particular, FIGs. 6G-6H refer to a case in which the defect is a short circuit (zero impedance).

Prior to t=t₀, the counter is disabled. When the signal crosses Vₜₕ₁, the counter is enabled and as a result starts counting clock cycles. At =t₃, the signal returns to zero since the connection is shorted. As the signal crosses Vₜₕ₂, the counter is disabled and as a result stops counting. The output of the counter, Y1 in this case, is indicative of the time passed between t₀ and t₃, as a result, of the location of the shorted connection. In essence, in the low-impedance mode, the counter may be viewed as being configured to measure the width of the signal pulse.

In the example of FIGs. 6I-6J, the impedance of the defect is 20Ω. As in the previous case, a counter is activated when the signal crosses Vₜₕ₁. A counter is then deactivated when the signal crosses Vₜₕ₂, thus producing Y1. Another counter is configured to be deactivated by the signal falling below Vₜₕ₁. However, Vₜₕ₁ is never crossed. Assuming for example, that the signal is 0.285V and that Vₜₕ₁ is set to 0.25V, the signal never falls below the threshold. As a result, the counter overflows. Accordingly, it may be inferred that the signal, after t₃, is between Vₜₕ₂ (e.g., 0.3V) and Vₜₕ₁=0.25V, and that the impedance is between 21.4Ω and 16.7Ω.

The example of FIGs. 6K-6L illustrates why the low-impedance mode may not be suitable for defects with impedance greater than 50Ω (or other expected values of impedance). In this case, the impedance of the defect is infinite (open circuit). As in the previous cases, the counter is enabled when the signal crosses Vₜₕ₁. However, the signal never crosses Vₜₕ₂, and as a result the counter overflows, thus providing no useful information.

### V. Iterative methods for non-digitizing time-domain reflectometry

The example of FIG. 3 illustrates a case in which the first and second transitions have the same amplitude (0.5V). This may occur because the output impedance of the signal driver matches the characteristic impedance of the electrical line and the input impedance of the load. In this case, setting the thresholds to 0.2V and 0.8V, respectively, would ensure proper operation of the methods and circuits describe above. In other circumstances, however, the impedances may be unmatched. This may result in the first and second signal transitions having different amplitudes. Unfortunately, due to the unpredictable nature of the impedance values, the extent to which the amplitude of the first signal transition differs from the amplitude of the second transition may not be known a priori. As a result, it may be difficult to set threshold values that are suitable for all situations.

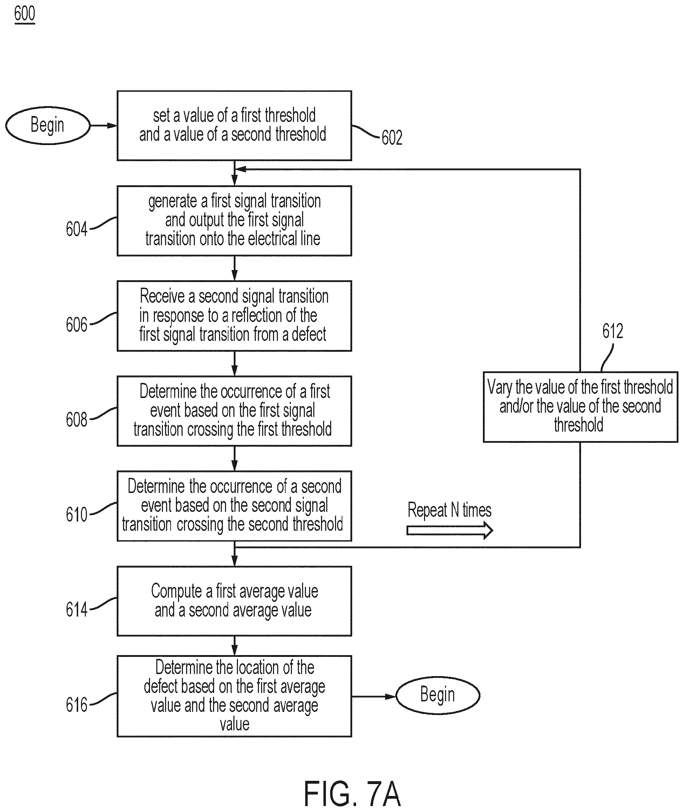

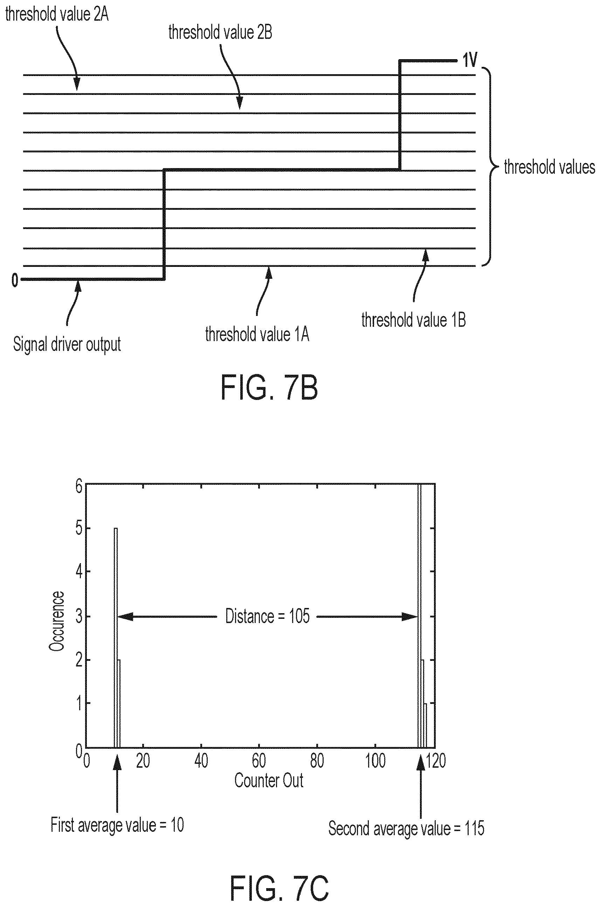

To obviate this problem, an iterative TDR method may be used, in which the value of the thresholds is varied over time, and in which the location of the defect is determined statistically. This method is illustrated in FIGs. 7A-7C. Method 600 (FIG. 7A) may begin at act 602, in which the first threshold is set to a certain value and the second threshold is set to another value. As shown in FIG. 7B, the first threshold may be initially set to value 1A, and the second threshold to value 2A. While the method is described in connection with a circuit operating in the high-impedance mode, it should be appreciated that a similar method may be used in the low-impedance mode.

At act 604, a first signal transition (e.g., signal transition 310, FIG. 4) may be generated and output onto the electrical line to be monitored. At act 606, a second signal transition (e.g., signal transition 311, FIG. 4) may be received in response to the first signal transition reflecting against the defect along the electrical line. At act 608, the occurrence of a first event may be determined based on the first signal transition crossing the first threshold. At act 610, the occurrence of a second event may be determined based on the second signal transition crossing the second threshold. At act 612, the value of the first threshold and/or the value of the second threshold may be varied. For example, as shown in FIG. 7B, the first threshold may be set to value 1B and the second threshold to value 2B. Acts 604-612 may then be repeated N times, where N>0. In some embodiments, the values of both thresholds are varied at the same iteration. In other embodiments, only the value of a threshold is varied during an iteration, and the value of the other threshold may be separately varied during a subsequent iteration.

FIG. 7C is a histogram illustrating, in the high-impedance mode, the occurrences of the first events (first signal transitions crossing the first threshold) and the occurrences of the second events (second signal transitions crossing the second threshold) where the first and second thresholds are varied as shown in FIG. 7B. The histogram is plotted as a function of time expressed in clock cycles.

At act 614, a first representative measurement value (e.g., a majority vote, or an average value) may be computed based on the occurrences of the first crossing events and a second representative measurement value may be computed based on the occurrences of the second crossing events. These representative measurement values may represent the average clock counts at the time when crossing events occur. For example, the representative measurement values may be computed by computing the majority votes, or the average values (e.g., the arithmetic mean, the geometric mean, the median, etc.) of the distributions shown in FIG. 7C. The first and second representative measurement values are equal to 10 and 115, respectively, in this example.

At act 616, the location of the defect may be determined based on the first and second representative measurement values. For example, the location of the defect may be determined by computing the difference between the second representative measurement value and the first representative measurement value. As illustrated in FIG. 7C, this difference is equal to 105 clock cycles in this example. The location of the defect may be computed using this expression: Δx =vP(Δcount), where v is the velocity of the waveform, P is the periodicity of the clock, and Δcount is the difference between the first representative measurement value and the second representative measurement value (105 in this case).

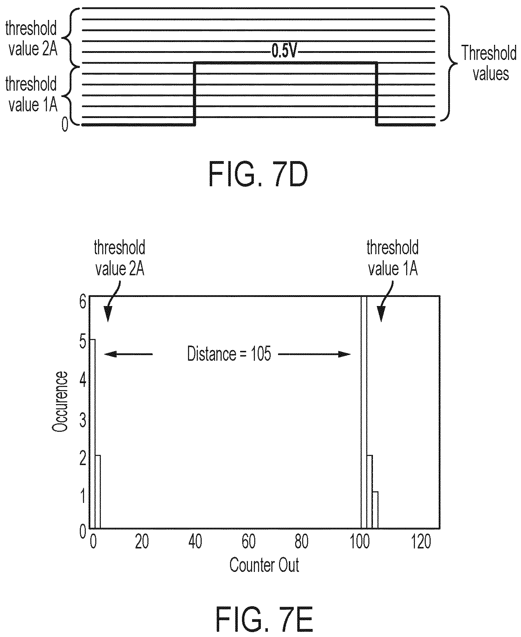

FIG. 7D illustrates a representative set of thresholds for use in the low-impedance mode, and FIG. 7E illustrates a correspond histogram. As shown, the histogram illustrates the occurrences of the two consecutive events (signal positively crossing the first threshold and signal negatively crossing the same threshold) and the occurrences of no such event (corresponding to threshold value 2A). Based on the statistics of these events, the location of the defect may be determined (counter overflow is not considered).

### VI. Digitizing methods and circuits for time-domain reflectometry

The TDR methods described above may be sufficient when a user wishes to determine the location of defects along one or more electrical lines of an electronic system. In other contexts, however, a user may wish to determine, in addition or in alternative to the location, other characteristics of a defect, including for example the electrical impedance of the defect and/or the nature of the defect (such as whether the defect is a short, an open, a poorly soldered connection, an unusually high-resistance pin, etc.).

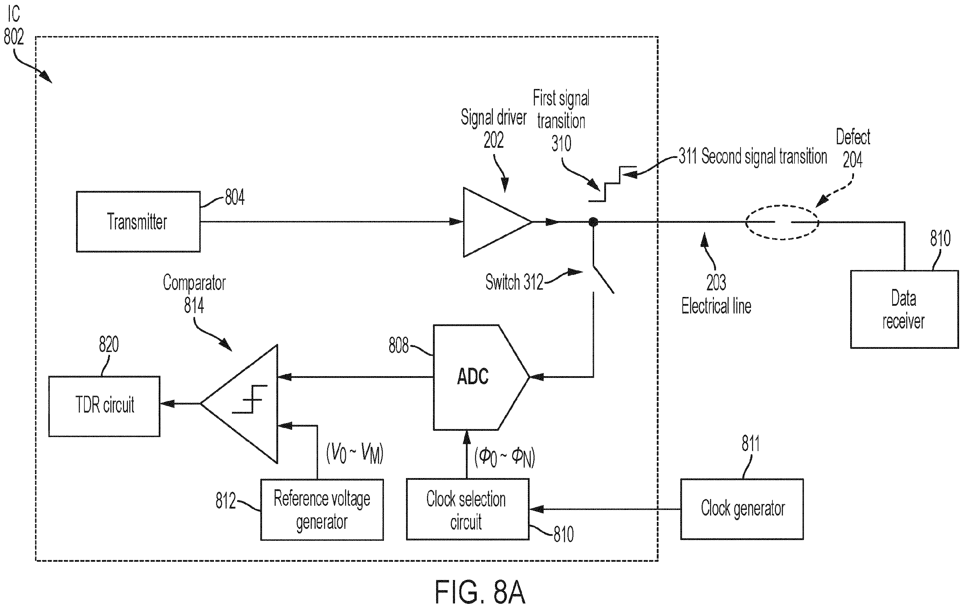

The inventors have recognized that, in such contexts, it may be desirable to profile the waveform of the TDR signal, which in turn, may involve sampling and digitizing the TDR signal. A representative circuit for performing time-domain reflectometry in this manner is illustrated in FIG. 8A, in accordance with some embodiments. IC 802 may be designed to operate in at least two modes. In the transmit mode, IC 802 is configured to generate data (for example in the form of bits) representative of information and to transmit the data to a receiver. The data may represent, for example, text information, visual information (e.g., video or image), sound information, location information, numerical information, financial information, etc. In the TDR mode, IC 802 is configured to perform time-domain reflectometry. Accordingly, the same hardware of IC 802 may be used for two purposes-to transmit data to another electronic circuit and to perform time-domain reflectometry-thus enabling testing without major disruptions to the operations of the IC.

IC 802 includes, among other components, a transmitter 804, a signal driver 202, a switch 312, an analog-to-digital converter (ADC) 808, a clock selection circuit 810, a reference voltage generator 812, a comparator 814, and a time-domain reflectometry (TDR) circuit 820. In the transmit mode, transmitter 804 generates data representing information to be transmitted to a receiver. Transmitter 804 can be designed to operate according to any communication protocol, including for example the "56G" standard (operating at 56Gb/s) and the "112G" standard (operating at 112Gb/s). Other communication standards are also possible. In some embodiments, transmitter is designed to transmit data at rates in excess of 1Gb/s. In the transmit mode, switch 312 may be open.

As described above in connection with FIG. 2A, signal driver 202 may include amplifiers, buffers, digital-to-analog converters, or other circuitry for outputting signals onto electrical line 203. Signal driver 202, outputs on electrical line 203 signals received from transmitter 804. Data receiver 810 is position at the opposite end of electrical line 203 relative to signal driver 202. Data receiver 810 can be part of any electronic circuit, and may include amplifiers, filters, analog-to-digital converters, processors, memories, etc.

In the TDR mode, transmitter 804 generates signal transitions for performing time-domain reflectometry. For example, transmitter 804 outputs signal transitions similar to those described above in connection with FIG. 2B. Signal driver 202 outputs a first signal transition 310 onto electrical line 203. When a defect 204 is present on the electrical line, a second signal transition 311 arises in response to reflection of the first signal transition 310 from defect 204. The amplitude of second signal transition 311 may depend, among other factors, on the nature of the defect, as described above in connection with FIGs. 2C-2G.

In the TDR mode, switch 312 is closed. As a result, the signal present on electrical line 203, which includes first transition 310 and second transition 311, is coupled to ADC 808. ADC 808 is configured to sample and digitize the received signal, or at least the portion of the received signal that includes transitions 310 and 311.

In some embodiments, ADC 808 is configured to operate at a relatively low frequency, thereby reducing the complexity of the ADC circuit and reducing power consumption. For example, ADC 808 may sample at a frequency that is less than 1/(t₃-t₀) (see FIGs. 2D-2G). Nonetheless, ADC 808 may be controlled to sample the signal with a sufficiency high resolution to profile the portion of the signal in which the transitions takes place. This may be accomplished, in some embodiments, by generating multiple instances of the first signal transition 310 (thereby generating multiple instances of the second signal transition 311), and for each instance, by sampling the signal with a different clock signal. In some embodiments, the clock signals used for sampling the different instances of the signal may be delayed replicas of a master clock signal. The delay between the clock signals may be sufficiently small to enable a high overall sampling resolution.

The timing with which ADC 808 samples the signals is controlled by clock selection circuit 810. Clock selection circuit 810 is configured to select one of a plurality of selectable clock signals. For example, clock section circuit 810 may receive a master clock signal from a clock generator 811, and may output one among a plurality of clock signals Φ₀... Φ_{N'} each of such clock signals having a different delay relative to the master clock signal. For example, clock signal Φ₀ may be obtained by introducing no delay, clock signal Φ₁ may be obtained by delaying the master clock signal by δt, clock signal Φ₂ may be obtained by delaying the master clock signal by 2δt, and clock signal Φ_{N} may be obtained by delaying the master clock signal by Nδt. N is an integer number greater than 1. In some embodiments, delay 6t is less than t₃-t₀.

Thus, clock selection circuit 810 may select one among the following selectable delays: 0, δt, 2δt... Nδt, and output a clock signal based on the selected delay. It should be appreciated that, while in this example the delays are incremented in a linear fashion, not all embodiments are limited in this respect as the delays may be incremented in any other suitable way.

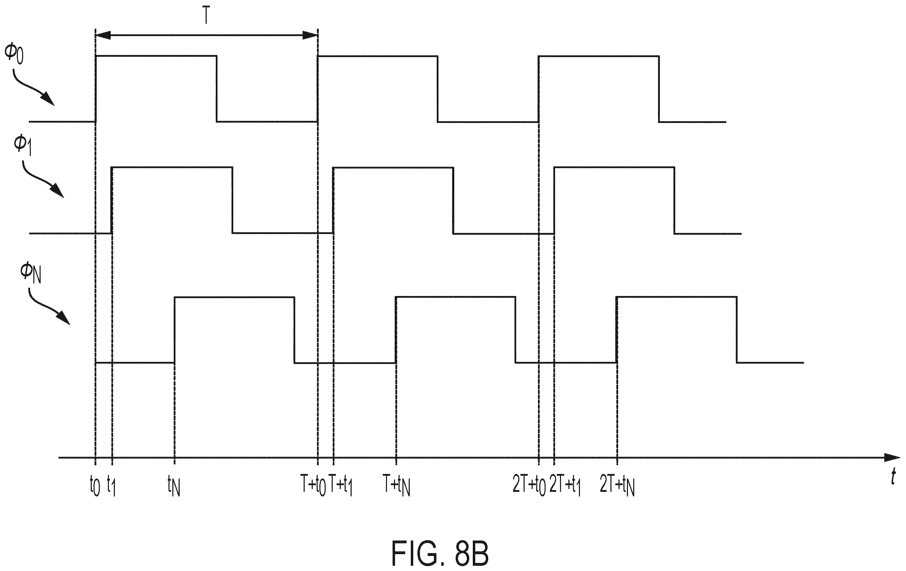

Examples of clock signals that may be output depending on the selected delay are illustrated in FIG. 8B, in accordance with some non-limiting embodiments. Clock signals Φ₀, Φ₁ and Φ_{N} are replicas of the same master clock, but are delayed by different amounts. In this example, the rising edges of clock signal Φ₀ occur at t=t₀, t=T+t₀, 2T+ t₀, etc. (where T indicates the periodicity of the clock signal), the rising edges of clock signal Φ₁ occur at t=t₁, t=T+t₁, 2T+ t₁, etc. and the rising edges of clock signal Φ_{N} occur at t=t_{N}, t=T+t_{N}, 2T+ t_{N}, etc.

ADC 808 samples the signal with a timing determined by the selected clock signal (e.g., at the rising edge or the falling edge of the selected clock signal). The output of ADC 808 is a plurality of numerical values representing the voltage of the signal at the time of sampling. For example, when clock signal Φ₀ is selected, ADC 808 produces a first numerical value at t=t₀, a second numerical value at t=T+t₀, a third numerical value at t=2T+t₀, etc.

Comparator 814 compares the numerical values produced by ADC 808 with a reference voltage. The output of comparator 814 is 1 if the output of ADC 808 exceeds the reference voltage, and is 0 otherwise (though the opposite logic may alternatively be used).

Reference voltage generator 812 selects the reference voltage to be compared with the output of ADC 808. In some embodiments, reference voltage generator 812 selects one reference voltage among a plurality of selectable voltages V₀...V_{M}, where M is an integer number greater than 1. The larger the value of M, the greater the resolution with which the circuit determines the voltage of the signal. Comparator 814 outputs a plurality of output values. A first output value results from the comparison of the numerical value obtained by sampling the signal at t=t₀ with the selected reference voltage, a second output value results from the comparison of the numerical value obtained by sampling the signal at t=T+t₀ with the selected reference voltage, a third output value results from the comparison of the numerical value obtained by sampling the signal at t=2T+t₀ with the selected reference voltage, etc. The output values represent, in essence, a digitized version of the signal received by ADC 808.

The output of the comparator is provided as input to TDR circuit 820. TDR circuit 820 may be programmed to determine a characteristic of the defect based on the output values. For example, TDR circuit 820 may be programmed to determine the location of the defect based on the difference between the time of the second signal transition 311 and the time of the first signal transition 310. Additionally, or alternatively, TDR circuit 820 may be programmed to determine the magnitude of the impedance of the defect based on the voltage of the signal after the second signal transition 311. Additionally, or alternatively, TDR circuit 820 may be programmed to determine whether the defect is a short, an open circuit, a poorly soldered connection, an unusually high-resistance pin, based on the voltage of the signal after the second signal transition 311.

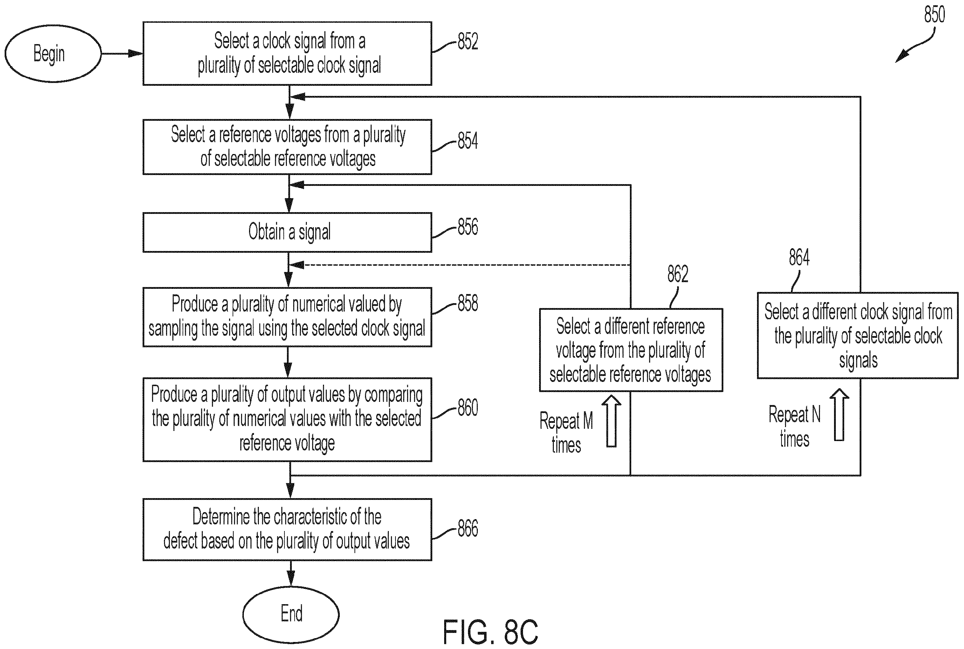

FIG. 8C is a flowchart illustrating a representative method for determining a characteristic of a defect, according to some non-limiting embodiments. The method of FIG. 8C may be executed using the integrated circuit of FIG. 8A, though any other suitable circuit may be used. The acts of method 850 may be executed in the order depicted in FIG. 8C, or in any other order. Method 850 begins at act 852, in which a clock signal is selected from a plurality of selectable clock signals. The plurality of clock signals may be delayed versions of a master clock signal, where each clock signal is delayed by a different amount. In some embodiments, selecting a clock signals comprises selecting a delay value and delaying the master clock signal by an amount that corresponds to the selected delay value.

At act 854, a reference voltage is selected among a plurality of M selectable voltages. The selectable voltages may be, for example, between 0 and V_{DD} or between -V_{DD} and V_{DD}.

At act 856, a signal is obtained by producing a first signal transition onto an electrical line, and by receiving a second signal transition arising in response to a reflection of the first signal transition from the defect. Hence, the signal includes the first signal transition and the second signal transition.

At act 858, a plurality of numerical values are produced by sampling the signal using the selected clock signal. For example, a first numerical value is produced at or after a first edge (rising or falling) of the selected clock signal, a second numerical value is produced at or after a second edge of the selected clock signal, a third numerical value is produced at or after a third edge of the selected clock signal, etc.

At act 860, a plurality of output values are produced by comparing the plurality of numerical values to the selected reference voltage. For example, a first output value is produced by comparing the first numerical value of act 858 with the selected reference voltage, a second output value is produced by comparing the second numerical value of act 858 with the selected reference voltage, a third output value is produced by comparing the third numerical value of act 858 with the selected reference voltage, etc.

Method 850 may proceed iteratively. For example, method 850 may loop over the selectable reference voltages and may loop over the selectable clock signals. In some embodiments, the loop over the selectable reference voltages is the inner loop and the loop over the selectable clock signals is the outer loop, as depicted in the example of FIG. 8C. In other embodiments, the loop over the selectable reference voltages is the outer loop and the loop over the selectable clock signals is the inner loop.

Act 862 represents the loop over the reference voltages. At act 862, a reference voltage is selected that is different from the reference voltage selected at the previous iteration. Subsequently, another signal is obtained (act 856), a plurality of numerical values are produced (act 858), and a plurality of output values are produced (act 860). The loop over the reference voltages is repeated M times, where M is the number of selectable reference voltages. Optionally, the loop over the reference voltages may not include act 856, as depicted by the dashed line of FIG. 8C.

Act 864 represents the loop over the clock signals. At act 864, a clock signal is selected that is different from the clock signal selected at the previous iteration. Subsequently, a reference voltage is selected (act 854), another signal is obtained (act 856), a plurality of numerical values are produced (act 858), a plurality of output values are produced (act 860), and the loop over the reference voltages is repeated again M times. The loop over the clock signals is repeated N times, where N is the number of selectable clock signals. Thus, method 850 involves MxN iterations.

At act 866, a characteristic of the defect is determined based on the plurality of output values obtained over the MxN iterations. Examples of characteristics that may be determined at act 866 include the location of the defect, the impedance of the defect and the nature of the defect. In some embodiments, the location of the defect may be determined based on the time elapsed between a first signal transition and a second signal transition. In some embodiments, the impedance may of the defect may be determined based on the voltage level following the second signal transition relative to the voltage level prior to the second signal transition.

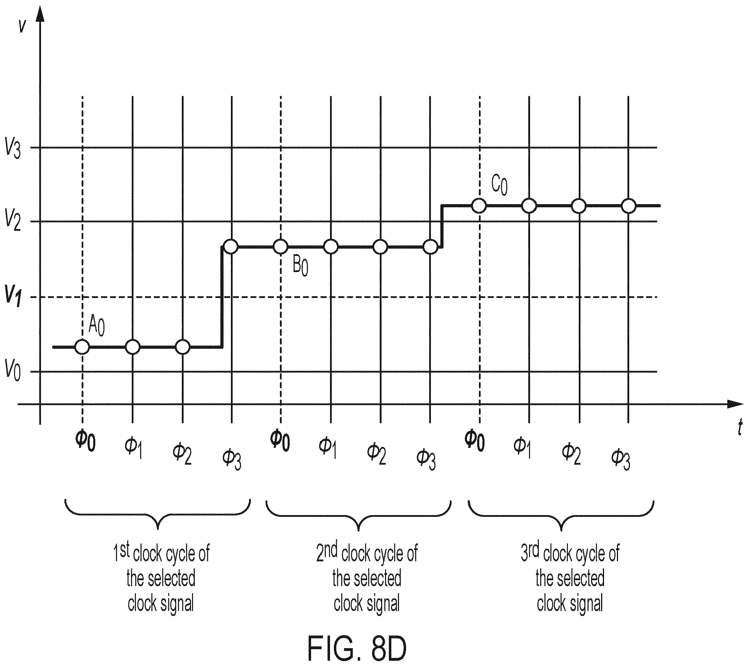

FIG. 8D is a plot illustrating how a signal may be sampled over several clock cycles, over several loops for the selectable clock signals and over several loops for the reference voltages, in accordance with some embodiments. Tables 8E-8H represent the outputs of the comparator 814. In this non-limiting example, the selectable clock signals are Φ₀, Φ₁, Φ₂ and Φ₃, and the selectable reference voltages are V₀, V₁, V₂ and V₃, though any other suitable numbers of clock signals and reference voltages may be used.

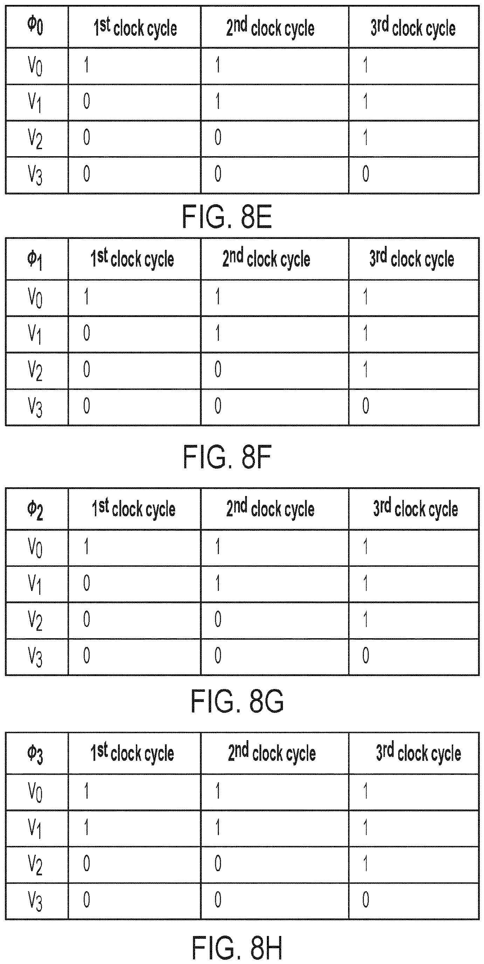

With reference to FIG. 8D and the table of FIG. 8E, the control circuit first selects clock signal Φ₀ and reference voltage V₀. In this loop, ADC 808 obtains, from the first instance of the signal, numerical value A₀ in the first clock cycle, numerical value B₀ in the second clock cycle and numerical value C₀ in the third clock cycle. Numerical values greater that the selected reference voltage result in the comparator producing a 1, while numerical values less than the selected reference voltage result in the comparator producing a 0 (though the opposite logic is also possible). Thus, when compared with reference voltage V₀, comparator 814 produced the following output values: 1 (at the first clock cycle), 1 (at the second clock cycle) and 1 (at the third clock cycle), as shown in the first row of the table of FIG. 8E.

Subsequently, a different reference voltage is selected: V₁. This time, as shown in the second row of the table of FIG. 8E, the output values are: 0 (at the first clock cycle), 1 (at the second clock cycle) and 1 (at the third clock cycle). The control circuit continues to loop over the selectable reference voltages. The subsequent output values are reflected in the last two rows of the table of FIG. 8E.

Subsequently, the control circuit selects a difference clock signal, Φ₁, and loops over the reference voltages. The output values when this clock signal is selected are shown in the table of FIG. 8F. Subsequently, the control circuit selects a difference clock signal, Φ₂, and loops over the reference voltages. The output values when this clock signal is selected are shown in the table of FIG. 8G. Lastly, the control circuit selects a difference clock signal, Φ₃, and loops over the reference voltages. The output values when this clock signal is selected are shown in the table of FIG. 8H.

The output values of the tables of FIGs. 8E-8H are stored in a memory of the control circuit, and are used to reconstruct the shape of the signal in the digital domain. The reconstructed signal can be post-processed to determine any characteristic of interest to the user, such as the location, impedance or nature of a defect.

As described above, some embodiments are directed to methods involving a loop arranged such that a different clock signal having a different delay is selected at each iteration of the loop. In this way, the portion of interest of the signal can be scanned with a reasonably high resolution in spite of using a relatively low-speed clock. Other embodiments, however, may scanning the signal involve a single clock signal but several replicas of the signal, where each replica has a different delay. Thus, instead of iterating over multiple selectable clock cycles, the method iterates over multiple selectable TDR signals.

Notwithstanding, the inventors has appreciated that, compared to methods that iterate over TDR signals having different delays, iterating over the selectable clock signals with different delays may reduce costs associated with the design and fabrication of the integrated circuit. This is particularly true in systems in which the transmitter hardware serves both as data transmitter and TDR transmitter. In these cases, in fact, enabling an integrated circuit to iterate over TDR signals having different delays involves redesigning at least part of a transmitter hardware that is already designed to perform data transmission. Vice versa, enabling an integrated circuit to iterate over clock signals having different delays can simply involve stamping a transmitter hardware template on the integrated circuit and adding, next to it, circuitry for selecting the different clock signals. This approach is more cost-efficient because its implementation may rely on pre-existing without transmitter hardware template.

Use of ordinal terms such as "first", "second", "third", etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Also, the phraseology and terminology used herein is for the purpose of description and should not be regarded as limiting. The use of "including", "comprising", "having", "containing" or "involving" and variations thereof herein, is meant to encompass the items listed thereafter and equivalents thereof as well as additional items.

The use of "coupled" or "connected" is meant to refer to circuit elements, or signals, that are either directly linked to one another or through intermediate components.

## Claims

1. A method for determining a characteristic of a defect (204) in an electrical line (203) of an electronic system, the method being carried out by an apparatus comprising a clock selection circuit (810), a reference voltage generator (812), a transmitter (804), an analog-to-digital converter (808), a comparator (814), and a time-domain reflectometry circuit (820), the method comprising:
(i) selecting a first clock signal (Φ₁) among a plurality of selectable clock signals (Φ₀... Φ_{N}), wherein each selectable clock signal exhibits a different delay (0, δt, 2δt...Nδt) relative to a master clock signal;
(ii) selecting a first reference voltage (V₁) among a plurality of selectable reference voltages (V₀...V_{M});
(iii) obtaining a signal by:
producing a first signal transition (310) onto the electrical line; and
receiving a second signal transition (311) arising in response to a reflection of the first signal transition from the defect;
(iv) producing a plurality of numerical values by digitizing the signal, wherein each numerical value represents a voltage of the signal, wherein the digitizing is timed using the selected clock signal;
(v) producing a plurality of output values by comparing the plurality of numerical values with the selected reference voltage; and
(vi) determining the characteristic of the defect based on the plurality of output values.

2. The method of claim 1, further comprising:
(vii) selecting a second reference voltage (V₂) different from the first reference voltage (V₁); and
(viii) repeating (iii)-(vi).

3. The method of claim 2, further comprising:
(ix) selecting a second clock signal (Φ₂) different from the first clock signal (Φ₁), such that the first and second clock signals exhibit different delays (δt, 2δt) relative to the master clock signal; and
(x) repeating (ii)-(vi).

4. The method of any preceding claim, wherein selecting the first clock signal (Φ₁) among the plurality of selectable clock signals (Φ₀... Φ_{N}) comprises selecting a delay value from a plurality of selectable delay values (0, δt, 2δt...Nδt) and delaying the master clock signal by an amount corresponding to the selected delay value.

5. The method of any preceding claim, wherein determining the characteristic of the defect (203) based on the plurality of output values comprises determining a location of the defect based on the plurality of output values.

6. The method of any preceding claim, wherein determining the characteristic of the defect (203) based on the plurality of output values comprises determining an impedance of the defect based on the plurality of output values.

7. The method of any preceding claim, wherein determining the characteristic of the defect (203) based on the plurality of output values comprises determining whether the defect is a short or an open circuit.

8. The method of any preceding claim, wherein producing the first signal transition (310) onto the electrical line (203) is performed using a signal driver (202), and wherein the method further comprises:
generating data comprising a plurality of bits representing information to be sent to a data receiver (810); and
with the signal driver, outputting the data onto the electrical line.

9. An apparatus for determining a characteristic of a defect (204) in an electrical line (203) of an electronic system, the apparatus comprising:
a clock selection circuit (810) configured to select a first clock signal (Φ₁) among a plurality of selectable clock signals (Φ₀...Φ_{N}), wherein each selectable clock signal exhibits a different delay (0, δt, 2δt...Nδt) relative to a master clock signal;
a reference voltage generator (812) configured to select a first reference voltage (V₁) among a plurality of selectable reference voltages (V₀...V_{M});
a transmitter (804) configured to obtain a signal by:
producing a first signal transition (310) onto the electrical line; and
receiving a second signal transition (311) arising in response to a reflection of the first signal transition from the defect;
an analog-to-digital converter (808) configured to produce a plurality of numerical values by digitizing the signal, wherein each numerical value represents a voltage of the signal, wherein the digitizing is timed using the selected clock signal;
a comparator (814) configured to produce a plurality of output values by comparing the plurality of numerical values with the selected reference voltage; and
a time-domain reflectometry circuit (820) configured to determine the characteristic of the defect based on the plurality of output values.

10. The apparatus of claim 9, wherein the reference voltage generator (812) is further configured to:
select a second reference voltage (V₂) different from the first reference voltage (V₁); and wherein the comparator (814) is further configured to produce a second plurality of output values by comparing the plurality of numerical values with the selected second reference voltage.

11. The apparatus of claim 10, wherein the clock selection circuit (810) is further configured to select a second clock signal (Φ₂) different from the first clock signal (Φ₁), such that the first and second clock signals exhibit different delays (δt, 2δt) relative to the master clock signal; and wherein the digitizing is timed using the selected second clock signal.

12. The apparatus of any of claims 9-11, wherein selecting the first clock signal (Φ₁) among the plurality of selectable clock signals (Φ₀... Φ_{N}) comprises selecting a delay value (δt) from a plurality of selectable delay values (0, δt, 2δt...Nδt) and delaying the master clock signal by an amount corresponding to the selected delay value.

13. The apparatus of any of claims 9-12, wherein determining the characteristic of the defect (204) based on the plurality of output values comprises determining an impedance of the defect based on the plurality of output values.

## Patentansprüche

1. Verfahren zum Bestimmen einer Charakteristik eines Defekts (204) in einer elektrischen Leitung (203) eines Elektroniksystems, wobei das Verfahren durch eine Vorrichtung ausgeführt wird, die eine Taktauswahlschaltung (810), einen Referenzspannungsgenerator (812), einen Sender (804), einen Analog-zu-Digital-Wandler (808), einen Komparator (814) und eine Zeitdomänen-Reflektometrieschaltung (820) aufweist, wobei das Verfahren umfasst:
(i) Auswählen eines ersten Taktsignals (Φ₁) aus einer Mehrzahl von auswählbaren Taktsignalen (Φ₀ ... Φ_{N}), wobei jedes auswählbare Taktsignal eine andere Verzögerung (0, δt, 2δt ... Nδt) relativ zu einem Master-Taktsignal zeigt;
(ii) Auswählen einer ersten Referenzspannung (V₁) aus einer Mehrzahl von auswählbaren Referenzspannungen (V₀ ... V_{M});
(iii) Erhalten eines Signals durch:
Erzeugen eines ersten Signalübergangs (310) auf der elektrischen Leitung; und
Empfangen eines zweiten Signalübergangs (311), der als Reaktion auf eine Reflektion des ersten Signalübergangs von dem Defekt entsteht;
(iv) Erzeugen einer Mehrzahl von numerischen Werten durch Digitalisieren des Signals, wobei jeder numerische Wert eine Spannung des Signals repräsentiert, wobei das Digitalisieren unter Verwendung des ausgewählten Taktsignals zeitlich festgelegt ist;
(v) Erzeugen einer Mehrzahl von Ausgabewerten durch Vergleichen der Mehrzahl von numerischen Werten mit der ausgewählten Referenzspannung; und
(vi) Bestimmen der Charakteristik des Defekts basierend auf der Mehrzahl von Ausgabewerten.

2. Verfahren gemäß Anspruch 1, weiter umfassend:
(vii) Auswählen einer zweiten Referenzspannung (V₂), die zu der ersten Referenzspannung (V₁) verschieden ist; und
(viii) Wiederholen von (iii)-(vi).

3. Verfahren gemäß Anspruch 2, weiter umfassend:
(ix) Auswählen eines zweiten Taktsignals (Φ₂), das zu dem ersten Taktsignal (Φ₁) verschieden ist, sodass das erste und das zweite Taktsignal unterschiedliche Verzögerungen (δt, 2δt) relativ zu dem Master-Taktsignal zeigen; und
(x) Wiederholen von (ii)-(vi).

4. Verfahren gemäß einem der vorstehenden Ansprüche, wobei das Auswählen des ersten Taktsignals (Φ₁) aus der Mehrzahl von auswählbaren Taktsignalen (Φ₀, ..., Φ_{N}) ein Auswählen eines Verzögerungswerts aus einer Mehrzahl von auswählbaren Verzögerungswerten (0, δt, 2δt ... Nδt) und ein Verzögern des Master-Taktsignals um einen Betrag, der zu dem ausgewählten Verzögerungswert korrespondiert, umfasst.

5. Verfahren gemäß einem der vorstehenden Ansprüche, wobei das Bestimmen der Charakteristik des Defekts (203) basierend auf der Mehrzahl von Ausgabewerten ein Bestimmen eines Orts des Defekts basierend auf der Mehrzahl von Ausgabewerten umfasst.

6. Verfahren gemäß einem der vorstehenden Ansprüche, wobei das Bestimmen der Charakteristik des Defekts (203) basierend auf der Mehrzahl von Ausgabewerten ein Bestimmen einer Impedanz des Defekts basierend auf der Mehrzahl von Ausgabewerten umfasst.

7. Verfahren gemäß einem der vorstehenden Ansprüche, wobei das Bestimmen der Charakteristik des Defekts (203) basierend auf der Mehrzahl von Ausgabewerten ein Bestimmen umfasst, ob der Defekt ein Kurzschluss oder eine Stromkreisunterbrechung ist.

8. Verfahren gemäß einem der vorstehenden Ansprüche, wobei das Erzeugen des ersten Signalübergangs (310) auf der elektrischen Leitung (203) unter Verwendung eines Signaltreibers (202) ausgeführt wird, und wobei das Verfahren weiter umfasst:
Generieren von Daten, die eine Mehrzahl von Bits aufweisen, die Informationen repräsentieren, die zu einem Datenempfänger (810) zu senden sind; und
Ausgeben der Daten auf die elektrische Leitung mit dem Signaltreiber.

9. Vorrichtung zum Bestimmen einer Charakteristik eines Defekts (204) in einer elektrischen Leitung (203) eines Elektroniksystems, wobei die Vorrichtung aufweist:
eine Taktauswahlschaltung (810), die eingerichtet ist, ein erstes Taktsignal (Φ₁) aus einer Mehrzahl von auswählbaren Taktsignalen (Φ₀ ... Φ_{N}) auszuwählen, wobei jedes auswählbare Taktsignal eine andere Verzögerung (0, δt, 2δt ... Nδt) relativ zu einem Master-Taktsignal zeigt;
einen Referenzspannungsgenerator (812), der eingerichtet ist, eine erste Referenzspannung (V₁) aus einer Mehrzahl von auswählbaren Referenzspannungen (Vo ... V_{M}) auszuwählen;
einen Sender (804), der eingerichtet ist, ein Signal zu erhalten durch:
Erzeugen eines ersten Signalübergangs (310) auf der elektrischen Leitung; und
Empfangen eines zweiten Signalübergangs (311), der als Reaktion auf eine Reflektion des ersten Signalübergangs von dem Defekt entsteht;
einen Analog-zu-Digital-Wandler (808), der eingerichtet ist, eine Mehrzahl von numerischen Werten durch Digitalisieren des Signals zu erzeugen, wobei jeder numerische Wert eine Spannung des Signals repräsentiert, wobei das Digitalisieren unter Verwendung des ausgewählten Taktsignals zeitlich festgelegt ist;
einen Komparator (814), der eingerichtet ist, eine Mehrzahl von Ausgabewerten durch Vergleichen der Mehrzahl von numerischen Werten mit der ausgewählten Referenzspannung zu erzeugen; und
eine Zeitdomänen-Reflektometrieschaltung (820), die eingerichtet ist, die Charakteristik des Defekts basierend auf der Mehrzahl von Ausgabewerten zu bestimmen.

10. Vorrichtung gemäß Anspruch 9, wobei der Referenzspannungsgenerator (812) weiter eingerichtet ist zum:
Auswählen einer zweiten Referenzspannung (V₂), die zu der ersten Referenzspannung (V₁) verschieden ist; und
wobei der Komparator (814) weiter eingerichtet ist, eine zweite Mehrzahl von Ausgabewerten durch Vergleichen der Mehrzahl von numerischen Werten mit der ausgewählten zweiten Referenzspannung zu erzeugen.

11. Vorrichtung gemäß Anspruch 10, wobei die Taktauswahlschaltung (810) weiter eingerichtet ist, ein zweites Taktsignal (Φ₂), das zu dem ersten Taktsignal (Φ₁) verschieden ist, auszuwählen, sodass das erste und das zweite Taktsignal unterschiedliche Verzögerungen (δt, 2δt) relativ zu dem Master-Taktsignal zeigen; und wobei das Digitalisieren unter Verwendung des ausgewählten zweiten Taktsignals zeitlich festgelegt ist.

12. Vorrichtung gemäß einem der Ansprüche 9-11, wobei das Auswählen des ersten Taktsignals (Φ₁) aus der Mehrzahl von auswählbaren Taktsignalen (Φ₀ ... Φ_{N}) ein Auswählen eines Verzögerungswerts (δt) aus einer Mehrzahl von auswählbaren Verzögerungswerten (0, δt, 2δt ... Nδt) und ein Verzögern des Master-Taktsignals um einen Betrag, der zu dem ausgewählten Verzögerungswert korrespondiert, umfasst.

13. Vorrichtung gemäß einem der Ansprüche 9-12, wobei das Bestimmen der Charakteristik des Defekts (204) basierend auf der Mehrzahl von Ausgabewerten ein Bestimmen einer Impedanz des Defekts basierend auf der Mehrzahl von Ausgabewerten umfasst.

## Revendications

1. Procédé pour déterminer une caractéristique d'un défaut (204) dans une ligne électrique (203) d'un système électronique, le procédé étant réalisé par un appareil comprenant un circuit de sélection d'horloge (810), un générateur de tension de référence (812), un transmetteur (804), un convertisseur analogique-numérique (808), un comparateur (814), et un circuit de réflectométrie dans le domaine temporel (820), le procédé comprenant :
(i) la sélection d'un premier signal d'horloge (Φ₁) parmi une pluralité de signaux d'horloge sélectionnables (Φ₀... Φ_{N}), dans lequel chaque signal d'horloge sélectionnable présente un retard différent (0, δt, 2δt... Nδt) par rapport à un signal d'horloge maître ;
(ii) la sélection d'une première tension de référence (V₁) parmi une pluralité de tensions de référence sélectionnables (V₀... V_{M}) ;
(iii) l'obtention d'un signal en :
produisant une première transition de signal (310) sur la ligne électrique ; et
recevant une deuxième transition de signal (311) apparaissant en réponse à une réflexion de la première transition de signal à partir du défaut ;
(iv) la production d'une pluralité de valeurs numériques en échantillonnant le signal, dans lequel chaque valeur numérique représente une tension du signal, dans lequel la numérisation est temporisée en utilisant le signal d'horloge sélectionné ;
(v) la production d'une pluralité de valeurs de sortie en comparant la pluralité de valeurs numériques avec la tension de référence sélectionnée ; et
(vi) la détermination de la caractéristique du défaut sur la base de la pluralité de valeurs de sortie.

2. Procédé selon la revendication 1, comprenant en outre :
(vii) la sélection d'une deuxième tension de référence (V₂) différente de la première tension de référence (V₁) ; et
(viii) la répétition de (iii)-(vi).

3. Procédé selon la revendication 2, comprenant en outre :
(ix) la sélection d'un deuxième signal d'horloge (Φ₂) différent du premier signal d'horloge (Φ₁), de telle sorte que les premier et deuxième signaux d'horloge présentent des retards différents (δt, 2δt) par rapport au signal d'horloge maître ; et
(x) la répétition de (ii)-(vi).

4. Procédé selon l'une des revendications précédentes, dans lequel la sélection du premier signal d'horloge (Φ₁) parmi la pluralité de signaux d'horloge sélectionnables (Φ₀... Φ_{N}) comprend la sélection d'une valeur de retard parmi une pluralité de valeurs de retard sélectionnables (0, δt, 2δt... Nδt) et le retard d'un signal d'horloge maître d'une valeur correspondant à la valeur de retard sélectionnée.

5. Procédé selon l'une des revendications précédentes, dans lequel la détermination de la caractéristique du défaut (203) sur la base de la pluralité de valeurs de sortie comprend la détermination d'un emplacement du défaut sur la base de la pluralité de valeurs de sortie.

6. Procédé selon l'une des revendications précédentes, dans lequel la détermination de la caractéristique du défaut (203) sur la base de la pluralité de valeurs de sortie comprend la détermination d'une impédance du défaut sur la base de la pluralité de valeurs de sortie.

7. Procédé selon l'une quelconque des revendications précédentes, dans lequel la détermination de la caractéristique du défaut (203) sur la base de la pluralité de valeurs de sortie comprend la détermination si le défaut est un court-circuit ou un circuit ouvert.

8. Procédé selon l'une des revendications précédentes, dans lequel la production de la première transition de signal (310) sur la ligne électrique (203) est effectuée en utilisant un pilote de signal (202), et dans lequel le procédé comprend en outre :
la génération de données comprenant une pluralité de bits représentant des informations à envoyer à un récepteur de données (810) ; et
avec le pilote de signal, la délivrance des données sur la ligne électrique.

9. Appareil pour déterminer une caractéristique d'un défaut (204) dans une ligne électrique (203) d'un système électronique, l'appareil comprenant :
un circuit de sélection d'horloge (810) configuré pour sélectionner un premier signal d'horloge (Φ₁) parmi une pluralité de signaux d'horloge sélectionnables (Φ₀... Φ_{N}), dans lequel chaque signal d'horloge sélectionnable présente un retard différent (0, δt, 2δt... Nδt) par rapport à un signal d'horloge maître ;
un générateur de tension de référence (812) configuré pour sélectionner une première tension de référence (V₁) parmi une pluralité de tensions de référence sélectionnables (V₀... V_{M}) ;
un transmetteur (804) configuré pour obtenir un signal en :
produisant une première transition de signal (310) sur la ligne électrique ; et
recevant une deuxième transition de signal (311) apparaissant en réponse à une réflexion de la première transition de signal à partir du défaut ;
un convertisseur analogique-numérique (808) configuré pour produire une pluralité de valeurs numériques en échantillonnant le signal, dans lequel chaque valeur numérique représente une tension du signal, dans lequel la numérisation est temporisée en utilisant le signal d'horloge sélectionné ;
un comparateur (814) configuré pour produire une pluralité de valeurs de sortie en comparant la pluralité de valeurs numériques avec la tension de référence sélectionnée ; et
un circuit de réflectométrie dans le domaine temporel (820) configuré pour déterminer la caractéristique du défaut sur la base de la pluralité de valeurs de sortie.

10. Appareil selon la revendication 9, dans lequel le générateur de tension de référence (812) est configuré en outre pour :
sélectionner une deuxième tension de référence (V₂) différente de la première tension de référence (V₁) ; et
dans lequel le comparateur (814) est configuré en outre pour produire une deuxième pluralité de valeurs de sortie en comparant la pluralité de valeurs numériques avec la deuxième tension de référence sélectionnée.

11. Appareil selon la revendication 10, dans lequel le circuit de sélection d'horloge (810) est configuré en outre pour sélectionner un deuxième signal d'horloge (Φ₂) différent du premier signal d'horloge (Φ₁), de telle sorte que les premier et deuxième signaux d'horloge présentent des retards différents (δt, 2δt) par rapport au signal d'horloge maître ;
et dans lequel la numérisation est temporisée en utilisant le deuxième signal d'horloge sélectionné.

12. Appareil selon l'une des revendications 9-11, dans lequel la sélection du premier signal d'horloge (Φ1) parmi la pluralité de signaux d'horloge sélectionnables (Φ₀... Φ_{N}) comprend la sélection d'une valeur de retard (δt) parmi une pluralité de valeurs de retard sélectionnables (0, δt, 2δt... Nδt) et le retard d'un signal d'horloge maître d'une valeur correspondant à la valeur de retard sélectionnée.

13. Appareil selon l'une des revendications 9-12, dans lequel la détermination de la caractéristique du défaut (204) sur la base de la pluralité de valeurs de sortie comprend la détermination d'une impédance du défaut sur la base de la pluralité de valeurs de sortie.
